(19) Europäisches Patentamt
European Patent Office
Office européen des brevets

(11) EP 3 020 767 A1

(12) EUROPEAN PATENT APPLICATION
published in accordance with Art. 153(4) EPC

(43) Date of publication:
**18.05.2016 Bulletin 2016/20**

(21) Application number: **14823821.5**

(22) Date of filing: **03.07.2014**

(51) Int Cl.:
***C08L 101/10*** (2006.01) ***C08K 3/00*** (2006.01)
***C08K 5/00*** (2006.01) ***C08L 75/04*** (2006.01)
***H01B 1/22*** (2006.01) ***H01B 13/00*** (2006.01)
***H05K 1/09*** (2006.01) ***H05K 3/12*** (2006.01)

(86) International application number:
**PCT/JP2014/067804**

(87) International publication number:
**WO 2015/005220 (15.01.2015 Gazette 2015/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **11.07.2013 JP 2013145694**

(71) Applicant: **Cemedine Co., Ltd.**
**Tokyo 141-8620 (JP)**

(72) Inventors:
- **OKABE, Yusuke**
  **Tokyo 141-8620 (JP)**
- **SAITO, Atsushi**
  **Tokyo 141-8620 (JP)**

(74) Representative: **Peguet, Wilfried et al**
**Ipsilon Feray Lenne Conseil**
**Le Centralis**
**63, avenue du Général Leclerc**
**92340 Bourg-la-Reine (FR)**

(54) **PRODUCTION METHOD FOR ELECTRICALLY CONDUCTIVE CURED ARTICLE, ELECTRICALLY CONDUCTIVE CURED ARTICLE, CURING METHOD FOR PULSED LIGHT CURING COMPOSITION, AND PULSED LIGHT CURING COMPOSITION**

(57) Provided are a method of producing a conductive cured material applicable even to a heat-sensitive substrate while achieving rapid curability, a conductive cured material, a method of curing a pulse light-curable composition, and a pulse light-curable composition. A conductive cured material is formed by application of pulsed light to a composition including: (A) at least one moisture-curable resin selected from the group consisting of an organic polymer containing a cross-linkable silicon-containing group and a moisture-curable urethane-based organic polymer; (B) a conductive filler; and (C) a condensation catalyst.

EP 3 020 767 A1

## Description

### Technical Field

The present invention relates to a method of producing a conductive cured material through the curing by pulse-light irradiation, a method of curing a pulse light-curable composition, and a pulse light-curable composition.

### Background Art

On the occasion of fabricating electronic components including a variety of electronic circuit substrates, it has traditionally been carried out to bond elements or the like to a base material like a substrate by applying a coat of conductive adhesive to the base material and thermally curing the adhesive (see e.g. Patent Documents 1 and 2).

On the other hand, base materials usable as the substrates of electronic circuit boards cover a broad spectrum nowadays, and macromolecular materials having relatively low melting temperatures including PET (polyethylene terephthalate) have also come to be adopted, depending on their uses.

However, in the case of fabricating electronic circuit boards through application of conductive adhesive coatings and thermal curing of the coatings, the use of base materials including macromolecular materials having relatively low melting points, PET for example, for substrates has caused a problem of incurring deformation of the substrates during the thermal curing.

In addition, there has been known a method of incorporating a photo-polymerization initiator into a conductive adhesive and curing the resulting adhesive by exposure to light. However, because the photo-polymerization initiator incorporated according to such a method makes the adhesive cure under exposure to light, it becomes necessary to perform preparation working, charging working, and conveyance, storage and like operations in darkness or the like. Thus such a method has suffered problems of being inferior in stability and workability.

Further, in the case of a conductive curable composition of the type which can be cured by moisture at ordinary temperature, even when such a composition is applied to a substrate made from a heat-sensitive material like PET, there occurs no deformation of the substrate because no heating is required for curing of the composition. However, the curing of such a composition requires a long time. Thus such a case has also suffered a problem of resulting in long line takt (process working time).

In another case of using a UV cure type of acrylic-based conductive curable composition, depth curability is not good, and hence applying a thick coating of such a composition has raised a problem that the coating cannot be cured at deep depths.

### Related Art Documents

### Patent Documents

Patent Document 1: JP-A-2000-319622
Patent Document 2: JP-A-2005-89559

### Summary of the Invention

### Problems that the Invention is to Solve

The invention aims to provide a method of producing a conductive cured material applicable even to a heat-sensitive substrate while achieving rapid curability, a conductive cured material, a method of curing a pulse light-curable composition, and a pulse light-curable composition.

### Means for Solving the Problems

In order to solve the problems as mentioned above, a method of producing a conductive cured material according to the invention is characterized in that the conductive cured material is formed by applying pulsed light to a composition including: (A) at least one moisture-curable resin selected from the group consisting of an organic polymer containing a cross-linkable silicon-containing group and a moisture-curable urethane-based organic polymer; (B) a conductive filler; and (C) a condensation catalyst. In this specification, a composition which can be cured by irradiation with pulse light is referred to as a pulse light-curable composition.

Thus the moisture curing in the invention is promoted by irradiation with pulse light, and rapid curability develops. The term "rapid curability" as used in this specification means that curing is completed within 2 minutes, preferably within 1 minute. In the invention, as mentioned above, moisture curing is promoted by irradiation with pulse light, and hence the composition is cured within 2 minutes, preferably within 1 minute. Accordingly, the composition allows application to heat-sensitive base materials (e.g. PET) while achieving rapid curability. More specifically, because irradiation with pulsed light allows intermittent exposure of a substrate to high-energy light, there is no potential for the substrate to get hot, and it becomes possible to promote moisture curing.

In addition, the pulse light-curable composition contains substantially no photo-polymerization initiator (10 ppm or below) and is cured by irradiation with pulse light. Even when exposed to ordinary light such as sunlight during conveyance, storage and the like, the present composition undergoes no curing, and it develops rapid curability only after irradiation with pulse light. Consequently, there is neither necessity of having to perform conveyance, storage and like operations of the curable composition in darkness nor necessity of having to avoid exposing the curable composition to ordinary light such as sunlight, and hence the curable composition has advantages of being excellent in stability and workability. Further, the invention has an advantage of being excellent in deep curability in contrast to conductive curable compositions of UV cure type, because promotion of the moisture curing by irradiation with pulse light allows curing at deep depths even when a thick coat of the composition is applied.

Furthermore, it is preferable that the conductive cured material is formed on a substrate.

A method of curing a pulse light-curable composition according to the invention is characterized in that the curing is performed by applying pulsed light to a composition including: (A) (A) at least one moisture-curable resin selected from the group consisting of an organic polymer containing a cross-linkable silicon-containing group and a moisture-curable urethane-based organic polymer; (B) a conductive filler; and (C) a condensation catalyst.

A pulse light-curable composition according to the invention is characterized by including: (A) at least one moisture-curable resin selected from the group consisting of an organic polymer containing a cross-linkable silicon-containing group and a moisture-curable urethane-based organic polymer; (B) a conductive filler; and (C) a condensation catalyst.

A conductive cured material according to the invention is characterized as a material produced according to the aforementioned method for producing a conductive cured material.

An electronic circuit according to the invention is characterized by using the aforementioned conductive cured material. And it is preferable that a substrate and electronic components are bonded together through the medium of the conductive cured material. Alternatively, it is preferable that the electronic circuit is formed with the conductive cured material on a substrate through the use of an application or printing technique. The electronic circuit according to the invention is produced by bonding electronic components to a substrate to be provided with circuits through the use of the conductive cured material. Alternatively, the electronic circuit is produced by forming, on a substrate, electronic circuits with the conductive cured material through the use of an application or printing technique. For the substrate on which a circuit is to be formed, even a base material sensitive to heat, such as PET, can be used suitably.

## Advantages of the Invention

The invention brings about great effects of providing a method of producing a conductive cured material applicable even to a heat-sensitive substrate while achieving rapid curability, a conductive cured material, a method of curing a pulse light-curable composition, and a pulse light-curable composition.

## Mode for Carrying Out the Invention

Embodiments of the invention are illustrated below. However, these embodiments are exemplifications, and it is needless to say that various changes and modifications can be made to them without departing from the technical spirit and scope of the invention.

In a method of producing a conductive cured material according to the invention, the conductive cured material is formed by applying pulsed light to a composition including: (A) at least one moisture-curable resin selected from the group consisting of an organic polymer containing a cross-linkable silicon-containing group and a moisture-curable urethane-based organic polymer; (B) a conductive filler; and (C) a condensation catalyst.

In a method of curing a pulse light-curable composition according to the invention, the curing is performed by applying pulsed light to a composition including: (A) at least one moisture-curable resin selected from the group consisting of an organic polymer containing a cross-linkable silicon-containing group and a moisture-curable urethane-based organic polymer; (B) a conductive filler; and (C) a condensation catalyst.

A pulse light-curable composition according to the invention is a composition including: (A) at least one moisture-curable resin selected from the group consisting of an organic polymer containing a cross-linkable silicon-containing group and a moisture-curable urethane-based organic polymer; (B) a conductive filler; and (C) a condensation catalyst.

An organic polymer containing a cross-linkable silicon-containing group used as a moisture-curable resin (A) in a pulse light-curable composition according to the invention may be an organic polymer having a cross-linkable group containing a silicon-containing group and a main-chain structure formed of at least one kind of polymer selected from the group consisting of polyoxyalkylene polymers, saturated hydrocarbon polymers, (meth)acrylate polymers and diorganopolysiloxane polymers.

The cross-linkable silicon-containing group in the organic polymer is a group having a hydroxyl group or a hydrolysable group attached to a silicon atom and capable of crosslinking through the formation of a siloxane linkage. As typical examples of such a group, groups represented by the following formula (1) may be exemplified.

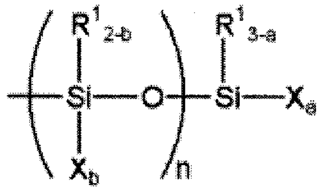 -----(1)

In the formula (1), $R^1$ represents an alkyl group having a carbon number of 1 to 20, a cycloalkyl group having a carbon number of 3 to 20, an aryl group having a carbon number of 6 to 20, an aralkyl group having a carbon number of 7 to 20 or a triorganosiloxy group represented by $R^1{}_3SiO$- ($R^1$ has the same meaning as the above), wherein when two or more $R^1$s are present each $R^1$ may be the same as or different from every other $R^1$. X represents a hydroxyl group or a hydrolysable group and, when more than one X is present, each X may be the same as or different from every other X. a represents 0, 1, 2 or 3, b represents 0, 1 or 2 and n represents an integer of 0 to 19, provided that the relation a+(total of b) $\geq$ 1 is satisfied. In addition, when n groups, each of which is represented by the following formula (2), are present, each b does not need to be the same as every other b.

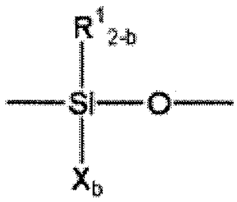 -----(2)

In the formula (2), 1 to 3 hydrolysable or hydroxyl groups can be attached to one silicon atom, and it is preferable for a+(total of b) to be in a range of 1 to 5. In the cases where two or more hydrolysable or hydroxyl groups are present in the cross-linkable silicon-containing group, each of them may be the same as or different from every other. The number of silicon atoms as constituents of the cross-linkable silicon-containing group may be one or more than one, and may be on the order of 20 when silicon atoms are linked to each other through siloxane bonding.

Of the cross-linkable silicon-contaning groups, those represented by the following formula (3) are preferred over the others in point of easy availability thereof.

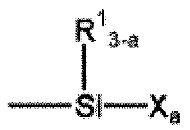 -----(3)

In the formula (3), $R^1$, X and a have the same meanings as the above, respectively.

Examples of the $R^1$ include an alkyl group such as a methyl group or an ethyl group, a cycloalkyl group such as a cyclohexyl group, an aryl group such as a phenyl group, an aralkyl group such as a benzyl group, and a triorganosiloxy group represented by $R^1{}_3SiO$-. Of these groups, a methyl group is preferable to the others.

The hydrolysable group represented by X has no particular restrictions, and it may be any of well-known hydrolysable groups. Suitable examples of such a hydrolysable group include a hydrogen atom, a halogen atom, an alkoxy group, an acyloxy group, a ketoxymate group, an amino group, an amido group, an acid amide group, an aminoxy group, a mercapto group and an alkenyloxy group. Among these groups, a hydrogen atom, an alkoxy group, an acyloxy group, a ketoxymate group, an amino group, an amido group, an aminoxy group, a mercapto group and an alkenyloxy group are preferable, and an alkoxy group, an amido group and an aminoxy group are more preferable. An alkoxy group

is particularly preferred in terms of moderate hydrolyzability and easy handling. Of alkoxy groups, an alkoxy group smaller in carbon number has the higher reactivity, or equivalently, the larger the carbon number, the lower the reactivity becomes in such a way that the reactivity in decreasing order is methoxy group>ethoxy group>propoxy group. Although any alkoxy group can be chosen in response to purposes and uses, a methoxy group or an ethoxy group is used in ordinary cases.

As to the cross-linkable silicon-containing groups represented by the formula (3), it is preferred that a is 2 or more with consideration given to their curability. The group in which a is 3 is generally greater in curing speed than the group in which a is 2.

Specific examples of a cross-linkable silicon-containing group in view of chemical structure include $-Si(OR)_3$, specifically a trialkoxysilyl group such as a trimethoxysilyl group or a triethoxysilyl group, and $-SiR^1(OR)_2$, specifically a dialkoxysilyl group such as a methyldimethoxysilyl group or a methyldiethoxysilyl group. Herein, R is an alkyl group such as a methyl group or an ethyl group.

In addition, only one kind of cross-linkable silicon-containing groups may be used, while it is also acceptable to use two or more kinds of cross-linkable silicon-containing groups in combination. The cross-linkable silicon-containing groups may be present in either main chain or side chains, or both. The number of silicon atoms as constituents of the cross-linkable silicon-containing group is one or more, but it is preferably 20 or less in cases where silicon atoms are linked to each other through siloxane bonding.

The cross-linkable organic polymer containing a silicon-containing group may be linear in structure, or may have branches. The number-average molecular weight of such a polymer is on the order of 500 to 100,000, preferably 1,000 to 50,000, particularly preferably 3,000 to 30,000, as measured by GPC and calculated in terms of polystyrene. Number-average molecular weight lower than 500 tends to bring about a disadvantage in point of extensibility of the resulting cured material, while number-average molecular weight higher than 100,000 results in high viscosity and tends to bring about a disadvantage in point of workability.

The number of cross-linkable silicon-containing groups present in an organic polymer has no particular limits, but in order to produce a rubber-like cured material exhibiting high strength, high extensibility and low elasticity modulus, it is preferable that the number of such groups averages at least one, preferably 1.1 to 5, per organic polymer molecule. When the average number of cross-linkable silicon-containing groups present in one molecule is smaller than one, the curing degree becomes insufficient, and it becomes difficult for the resulting cured material to develop good rubber elastic behavior.

Cross-linkable silicon-containing groups may be present at either main-chain or side-chain terminals of organic polymer molecule, or both. In special cases where cross-linkable silicon-containing groups are present only at main-chain terminals of organic polymer molecule, the effective length of the network of organic polymer molecule component present in the finally-formed cured material becomes long, and thereby it becomes easy to obtain a rubber-like cured material exhibiting high strength, high extensibility and low elasticity modulus.

The polyoxyalkylene polymer containing a cross-linkable silicon-containing group, usable as the organic polymers, is a polymer having repeating units represented substantially by the following formula (4).

$$-R^2-O- \qquad (4)$$

In the formula (4), $R^2$ is a straight- or branched-chain alkylene group having a carbon number of 1 to 14, and those suitable as $R^2$ include straight- and branched-chain alkylene groups containing from 1 to 14 carbon atoms, preferably from 2 to 4 carbon atoms.

Specific examples of a repeating unit represented by the formula (4) include $-CH_2O-$, $-CH_2CH_2O-$, $-CH_2CH(CH_3)O-$, $-CH_2CH(C_2H_5)O-$, $-CH_2C(CH_3)_2O-$ and $-CH_2CH_2CH_2CH_2O-$.

The main-chain structure of the polyoxyalkylene polymer may be made up of only one kind of repeating units, or it may be made up of two or more kinds of repeating units.

As examples of a method for synthesizing a polyoxyalkylene polymer, exemplified may be a polymerization method using an alkali catalyst such as KOH, a polymerization method using an organoaluminum-porphyrin complex catalyst obtained by making an organic aluminum compound react with porphyrin as disclosed in JP-A-61-197631, JP-A-61-215622 and JP-A-61-215623, and a polymerization method using a double metal cyanide complex catalyst as disclosed in JP-B-46-27250 and JP-B-59-15336. However, synthesis methods adoptable herein should not be construed as being limited to those methods in particular. According to the polymerization method using an organoaluminum-porphyrin complex catalyst or the polymerization method using double metal cyanide complex catalyst, it is possible to obtain a polyoxyalkylene polymer having high molecular weight, specifically a number-average molecular weight of 6,000 or above, and narrow molecular-weight distribution, specifically an Mw/Mn value of 1.6 or below.

The main-chain structure of the polyoxyalkylene polymer may contain other constituents including a urethane bond constituent. Examples of such a urethane bond constituent include aromatic polyisocyanates such as toluene (tolylene) diisocyanate, diphenylmethane diisocyanate and xylylene diisocyanate, and products of reaction between aliphatic polyisocyanates, such as isophorone diisocyanate and hexamethylene diisocyanate, and hydroxyl group-containing polyoxyalkylene polymers.

Introduction of a cross-linkable silicon-containing group into a polyoxyalkylene polymer can be performed by subjecting a polyoxyalkylene polymer containing in its molecule a functional group, such as an unsaturated group, a hydroxyl group, an epoxy group or an isocyanate group, to reaction with a compound having a functional group capable of reacting with the functional group as recited above as well as the cross-linkable silicon-containing group (this method of introduction is referred to as a macromolecular reaction method hereafter).

As an example of the macromolecular reaction method, exemplified may be a method of producing a polyoxyalkylene polymer containing a cross-linkable silicon-containing group through the hydrosilylation or mercaptization of an unsaturated group-containing polyoxyalkylene polymer with a hydrosilane containing a cross-linkable silicon-containing group or a mercapto compound containing a cross-linkable silicon-containing group, respectively. The unsaturated group-containing polyoxyalkylene polymer can be produced by subjecting an organic polymer having a functional group such as a hydroxyl group to reaction with an organic compound having an active group exhibiting reactivity to that functional group.

As other examples of the macromolecular reaction method, exemplified may be a method of subjecting a polyoxyalkylene polymer having hydroxyl groups at its terminals to reaction with a compound having an isocyanate group as well as a cross-linkable silicon-containing group and a method of subjecting a polyoxyalkylene polymer having isocyanate groups at its terminals to reaction with a compound having an active hydrogen-containing group, such as a hydroxyl group or an amino group, as well as a cross-linkable silicon-containing group. The use of an isocyanate compound allows easy production of a cross-linkable silicon-containing group-containing polyoxyalkylene polymer.

Examples of the polyoxyalkylene polymer containing a cross-linkable silicon-containing group can include the polymers proposed in each of JP-B-45-36319, JP-B-46-12154, JP-A-50-156599, JP-A-54-6096, JP-A-55-13767, JP-A-57-164123, JP-B-3-2450, JP-A-2005-213446, JP-A-2005-306891, International Patent Publication WO 2007-040143 and US Patent Nos. 3,632,557, 4,345,053 and 4,960,844.

The polyoxyalkylene polymers containing cross-linkable silicon-containing groups as recited above may be used alone or as a combination of any two or more thereof.

The saturated hydrocarbon polymer containing a cross-linkable silicon-containing group usable as the organic polymer is a polymer containing substantially no carbon-to-carbon unsaturated bond other than those in aromatic rings, and a polymer forming the carbon skeleton thereof can be produced e.g. by (1) performing polymerization using as a main monomer an olefin compound having a carbon number of 2 to 6, such as ethylene, propylene, 1-butene or isobutylene, or by (2) using a method of performing homopolymerization of a diene compound, such as butadiene or isoprene, or copolymerization of a diene compound and an olefin compound as cited above, and then subjecting the resulting polymer to hydrogenation. Of such polymers, an isobutylene polymer and a hydrogenated polybutadiene polymer are preferable to the others because it is easy to introduce functional groups into their terminals and to control their molecular weight, and besides, they have the capability of increasing the number of terminal functional groups. And an isobutylene polymer in particular is preferred.

Organic polymers whose main-chain structures are formed of saturated hydrocarbon polymers have the property of being excellent in heat resistance, weather resistance, durability and capability of blocking moisture.

As to the isobutylene polymer, all monomer units thereof may be constituted of isobutylene units, or it may be a copolymer formed of isobutylene units and other monomer units. However, from an aspect of rubber characteristics, it is preferable for the isobutylene polymer to contain repeating units derived from isobutylene in a proportion of at least 50 mass %, preferably at least 80 mass%, particularly preferably from 90 mass% to 99 mass%.

As to the syntheses of saturated hydrocarbon polymers, various polymerization methods have been reported previously, and many methods for the so-called living polymerization have been developed in recent years in particular. In the cases of saturated hydrocarbon polymers, notably isobutylene polymers, the use of the infer method found by Kennedy et al. (J.P. Kennedy et al., J. Polymer Sci., Polymer Chem. Ed. 1997, vol. 15, p. 2843) allows easy syntheses of those polymers, and is known to make it possible to perform polymerization ensuring molecular weight of the order of 500 to 100,000 and a molecular weight distribution of 1.5 or below and introduce various functional groups into molecular terminals.

Methods for producing a saturated hydrocarbon polymer containing a cross-linkable silicon-containing group are described in each of specifications including but not particularly limited to those of JP-B-4-69659, JP-B-7-108928, JP-A-63-254149, JP-A-64-22904, JP-A-1-197509, Japanese Patent Gazette Nos. 2539445 and 2873395, and JP-A-7-53882.

The saturated hydrocarbon polymers containing cross-linkable silicon-containing groups may be used alone or as a combination of any two or more thereof.

As to (meth)acrylic ester monomers forming the main chain of a (meth)acrylic ester polymer containing a cross-linkable silicon-containing group, usable as the organic polymer, there are no particular restrictions, and various ones can be used. Examples of such monomers include (meth)acrylic monomers such as (meth)acrylic acid, methyl (meth)acrylate, ethyl (meth)acrylate, n-propyl (meth)acrylate, isopropyl (meth)acrylate, n-butyl (meth)acrylate, isobutyl (meth)acrylate, tert-butyl (meth)acrylate, n-pentyl (meth)acrylate, n-hexyl (meth)acrylate, cyclohexyl (meth)acrylate, n-heptyl (meth)acrylate, n-octyl (meth)acrylate, 2-ethylhexyl (meth)acrylate, nonyl (meth)acrylate, decyl (meth)acrylate, dodecyl (meth)acrylate, phenyl (meth)acrylate, toluyl (meth)acrylate, benzyl (meth)acrylate, 2-methoxyethyl (meth)acrylate, 3-methoxybutyl (meth)acrylate, 2-hydroxyethyl (meth)acrylate, 2-hydroxypropyl (meth)acrylate, stearyl (meth)acrylate, glycidyl (meth)acrylate, 2-aminoethyl (meth)acrylate, $\gamma$-(methacryloyloxypropyl)trimethoxysilane, $\gamma$-(methacryloyloxypropyl)dimethoxymethylsilane, methacryloyloxymethyltrimethoxysilane, methacryloyloxymethyltriethoxysilane, methacryloyloxymethyldimethoxymethylsilane, methacryloyloxymethyldiethoxymethylsilane, ethylene oxide adduct of (meth)acrylic acid, trifluoromethylmethyl (meth)acrylate, 2-trifluoromethylethyl (meth)acrylate, 2-perfluoroethylethyl (meth)acrylate, 2-perfluoroethyl-2-perfluorobutylethyl (meth)acrylate, perfluoroethyl (meth)acrylate, trifluoromethyl (meth)acrylate, bis(trifluoromethyl)methyl (meth)acrylate, 2-trifluoromethyl-2-perfluoroethylethyl (meth)acrylate, 2-perfluorohexylethyl (meth)acrylate, 2-perfluorodecylethyl (meth)acrylate and 2-perfluorohexadecylethyl (meth)acrylate.

The (meth)acrylic ester polymers may be copolymers obtained by subjecting (meth)acrylic ester monomers to copolymerization with the following vinyl monomers. Examples of such vinyl monomers include styrene monomers, such as styrene, vinyltoluene, $\alpha$-methylstyrene, chlorostyrene, styrenesulfonic acid and salts thereof; fluorine-containing vinyl monomers, such as perfluoroethylene, perfluoropropylene and fluorinated vinylidene; silicon-containing vinyl monomers, such as vinyltrimethoxysilane and vinyltriethoxysilane; maleic anhydride, maleic acid, monoalkyl maleates and dialkyl maleates; fumaric acid, monoalkyl fumarates and dialkyl fumarates; maleimide monomers, such as maleimide, methylmaleimide, ethylmaleimide, propylmaleimide, butylmaleimide, hexylmaleimide, octylmaleimide, dodecylmaleimide, stearylmaleimide, phenylmaleimide and cyclohexylmaleimide; nitrile group-containing vinyl monomers, such as acrylonitrile and methacrylonitrile; amido group-containing vinyl monomers, such as acrylamide and methacrylamide; vinyl esters, such as vinyl acetate, vinyl propionate, vinyl pivalate, vinyl benzoate and vinyl cinnamate; alkenes, such as ethylene and propylene; conjugated dienes, such as butadiene and isoprene; and vinyl chloride, vinylidene chloride, allyl chloride and allyl alcohol.

The (meth)acrylic ester monomers and the vinyl monomers may be used alone or as a combination of any two or more thereof, and there is nothing wrong with copolymerizing one or more (meth)acrylic ester monomers and one or more vinyl monomers. Of such copolymers, copolymers produced from styrene monomers and (meth)acrylic ester monomers are preferred in terms of physical properties of the products. Far preferred ones are (meth)acrylic polymers formed from acrylic ester monomers and methacrylic ester monomers, and particularly preferred ones are acrylic polymers formed from acrylic ester monomers. In the invention, it doesn't matter to copolymerize these preferred monomers and other monomers, and that into block copolymers. In such copolymerization, it is preferable for those copolymers to contain the preferred monomers in a proportion of 40% by mass or above. By the way, the foregoing expression form, e.g. (meth)acrylic acid, represents acrylic acid and/or methacrylic acid.

The (meth)acrylic ester polymers have no particular limitations on their Tg, and every one of (meth)acrylic ester polymers of high Tg type and those of low Tg type can be used. Taking adhesiveness into consideration, the use of (meth)acrylic ester polymers of high Tg type is preferred. It is preferable for those of high Tg type to have their Tg in a range of 10°C to 180°C, preferably 20°C to 120°C. On the other hand, (meth)acrylic ester polymers of low Tg type are used suitably for imparting flexibility to cured materials so that they can be applied also to flexible substrates. It is preferable for those of low Tg type to have their Tg in a range of -60°C to 0°C, preferably -60°C to -30°C. In addition, it is preferred that (meth)acrylic ester polymers of high Tg type and low Tg type which have their Tg in their respective ranges mentioned above be used in combination. In the case of applying the pulse light-curable composition to flexible substrates, it is preferable that the low Tg type is mixed in a higher proportion than the high Tg type. Further, a (meth)acrylic ester polymer having its Tg within the foregoing range and a (meth)acrylic ester polymer having its Tg beyond the foregoing range may be used in combination. By the way, Tg in this specification is a computed glass transition temperature calculated from the following mathematical expression (I).

$$\frac{1}{Tg}=\sum\left(\frac{Wi}{Tgi}\right) \quad \cdots \quad (I)$$

In the mathematical expression (I), Tg is the computed glass transition temperature of a (meth)acrylic ester polymer containing a cross-linkable silicon-containing group, Wi is the weight fraction of a monomer i (wherefrom a compound containing a cross-linkable silicon-containing group is excluded), and Tgi is the glass transition temperature of a monomer i homopolymer.

The (meth)acrylic ester polymers have no particular restrictions as to their synthesis methods, and they may be synthesized according to known methods. However, polymers obtained by conventional free-radical polymerization methods using as polymerization initiators azo compounds, peroxides or the like bear a problem of generally having a great molecular-weight distribution value of 2 or above, and suffering a rise in viscosity. Accordingly, it is preferable to

use living radical polymerization methods for the purpose of obtaining (meth)acrylic ester polymers which are narrow in molecular-weight distribution and low in viscosity, what's more which are high in content of cross-linkable functional groups present at molecular terminals.

The (meth)acrylic ester polymers containing cross-linkable silicon-containing groups may be used alone or as a combination of any two or more thereof.

Those organic polymers containing cross-linkable silicon-containing groups may be used alone or as a combination of any two or more thereof. To be more specific, it is also possible to use a blend of two or more kinds of organic polymers selected from the group consisting of polyoxyalkylene polymers containing cross-linkable silicon-containing group, saturated hydrocarbon polymers containing cross-linkable silicon-containing groups and (meth)acrylic ester polymers containing cross-linkable silicon-containing groups.

Methods of producing organic polymers as blends of polyoxyalkylene polymers containing cross-linkable silicon-containing groups and (meth)acrylic ester polymers containing cross-linkable silicon-containing groups have been proposed e.g. in JP-A-59-122541, JP-A-63-112642, JP-A-6-172631 and JP-A-11-116763, but they should not be construed as being limited particularly to the methods proposed therein. A suitable example among such production methods is a method of producing an organic polymer by blending a polyoxyalkylene polymer containing a cross-linkable silicon-containing group with a copolymer having a cross-linkable silicon-containing group and a molecular chain formed substantially of (meth)acrylic ester monomer units containing alkyl groups having a carbon number of 1 to 8, represented by the following formula (5) and (meth)acrylic ester monomer units containing alkyl groups having a carbon number of no smaller than 10, represented by the following formula (6).

$$-CH_2-C(R^3)(COOR^4)- \qquad (5)$$

$$-CH_2-C(R^3)(COOR^5)- \qquad (6)$$

In the formula (5), $R^3$ represents a hydrogen atom or a methyl group, and $R^4$ represents am alkyl group having a carbon number of 1 to 8. The $R^4$ in the formula (5) is an alkyl group having a carbon number of 1 to 8, such as a methyl group, an ethyl group, a propyl group, an n-butyl group, a t-butyl group or a 2-ethylhexyl group, preferably an alkyl group having a carbon number of 1 to 4, far preferably an alkyl group having a carbon number of 1 or 2. Additionally, alkyl groups represented by $R^4$s may be the same ones or a mixture of different ones.

In the formula (6), $R^3$ has the same meaning as in the above, and $R^5$ represents an alkyl group having a carbon number of no smaller than 10. Examples of the $R^5$ in the formula (6) include long-chain alkyl groups having carbon numbers of at least 10 such as a lauryl group, a dodecyl group, a cetyl group, a stearyl group and behenyl group, normally those having carbon numbers of 10 to 30, preferably those having carbon numbers of 10 to 20. Additionally, as is the case with the $R^4$, alkyl groups represented by $R^5$s may be the same ones or a mixture of different ones.

The molecular chain of each of the (meth)acrylic ester copolymers is formed substantially of monomer units represented by the formula (5) and those represented by the formula (6). The wording "substantially" used herein means that the total proportion of the monomer units represented by the formula (5) and those represented by the formula (6) is higher than 50 mass%. The preferred total proportion of the monomer units represented by the formula (5) and those represented by the formula (6) is 70 mass% or higher.

In addition, the mass ratio between monomer units of the formula (5) and monomer units of the formula (6) present in one copolymer molecule is preferably from 95:5 to 40:60, far preferably from 90:10 to 60:40.

Examples of monomer units other than the monomer units of the formulae (5) and (6), which may be incorporated into the copolymers, include monomer units derived from $\alpha,\beta$-unsaturated carboxylic acids, such as acrylic acid and methacrylic acid; monomer units derived from monomers containing amido groups such as acrylamide, methacrylamide, N-methylol acrylamide and N-methylol methacrylamide, monomers containing epoxy groups such as glycidyl acrylate and glycidyl methacrylate, and monomers containing amino groups such as diethylaminoethyl acrylate, diethylaminoethyl methacrylate and aminoethyl vinyl ether; and monomer units derived from other monomers such as acrylonitrile, styrene, $\alpha$-methylstyrene, alkyl vinyl ethers, vinyl chloride, vinyl acetate, vinyl propionate and ethylene.

The organic polymers prepared by blending saturated hydrocarbon polymers containing cross-linkable silicon-containing groups with (meth)acrylic ester copolymers containing cross-linkable silicon-containing groups include those proposed e.g. in JP-A-1-168764 and JP-A-2000-186176, but they should not be construed as being limited particularly to those proposed therein.

As another method for production of organic polymers into which (meth)acrylic ester copolymers containing cross-linkable silicon-containing groups are blended, it is also possible to utilize the method of performing polymerization of (meth)acrylic ester monomers in the presence of cross-linkable organic polymers containing a silicon-containing group. This method for the production have been concretely disclosed in each of JP-A-59-78223, JP-A-59-168014, JP-A-60-228516 and JP-A-60-228517, but the method for production of those organic polymers should not be construed as being limited to the disclosed ones.

Examples of a diorganopolysiloxane polymer a cross-linkable silicon-containing group, usable as one kind of the organic polymers include polymers having a structure represented by the following formula (i).

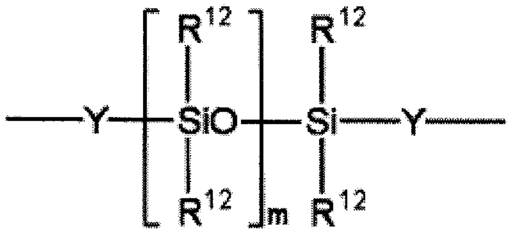

-----(i)

In the formula (i), $R^{12}$ is a group chosen from a univalent hydrocarbon group, a halogenated hydrocarbyl group or a cyanoalkyl group, with examples including 1-10C alkyl groups, such as a methyl group, an ethyl group, a propyl group, a butyl group and an octyl group; cycloalkyl groups, such as a cyclopentyl group and a cyclohexyl group; alkenyl groups, such as a vinyl group and an allyl group; an aryl group, such as a phenyl group, a tolyl group, and a naphthyl group; aralkyl groups, such as a benzyl group, a phenylethyl group and a phenylpropyl group; halogenated hydrocarbyl groups, such as a trifluoropropyl group and a chloropropyl group; and cyanoalkyl groups, such as a 2-cyanoethyl group or a 3-cyanopropyl group. Of these groups, a methyl group is preferred over the others. Y is an oxygen atom or a divalent hydrocarbon group. Suitable examples of the divalent hydrocarbon group include alkylene groups having a carbon number of 1 to 10, such as a methylene group, an ethylene group, a propylene group, a butylene group and a hexene group. And m is a number allowing the polymer to have a viscosity of 20 to 1,000,000 mPa-s at 25°C.

As a moisture-curable urethane-type organic polymer selectable as the moisture-curable resin (A) in the pulse light-curable composition to be used in the invention, widely known isocyanate group-containing polyurethane prepolymers produced through reaction between polyols and polyisocyanates can be used.

The polyols may be active hydrogen-containing compounds each of which has at least two active hydrogen-containing groups, and they are not limited to particular ones. Examples of such a compound include a polyether polyol, a polyester polyol, an amine polyol, a polycarbonate polyol, a polybutadiene polyol and an acrylic polyol. Of these polyols, a polyether polyol, a polyester polyol or an amine polyol is preferably used, and a polyether polyol in particular is suitable. The polyols having molecular weight of 100 to 12,000 and 2 to 4 OH groups per molecule can be preferably used. These polyols may be used alone or as a combination of any two or more thereof.

More specifically, examples of the polyether polyol include diols such as ethylene glycol, propylene glycol and butylene glycol, triols such as glycerin and trimethylol propane, and random or block copolymers produced by subjecting propylene oxide and/or ethylene oxide to ring-opening polymerization in the presence of one or more kinds of amines such as ammonia and ethylenediamine.

Examples of the polyester polyol include polyester polyols such as copolymers produced by subjecting adipic acid, sebacic acid, terephthalic acid or the like to polycondensation in the presence of ethylene glycol, propylene glycol, 1,4-butanediol, neopentyl glycol or the like, and low molecular-weight active halogen compounds each having two or more active hydrogen-containing groups, such as ram esters of bisphenol A and castor oil.

Suitable examples of the amine polyol include amine polyols which can be produced e.g. through the reaction where alkylene oxides are added to amine compounds and contain on average 3 or more functional groups per molecule. Examples of such amine compounds include ethylamine, butylamine, ocrylamine, laurylamine, aliphatic polyamines such as ethylenediamine, diethyltriamine, triethylenetetramine, tetraethylenepentamine, propylenediamine, methylaminomethylamine, methylaminoethylamine, ethylaminoethylamine, 1,2-diaminopropane, 1,3-diaminopropane, methylaminopropylamine, bis(3-aminopropyl) ether, 1,3-bis(3-aminopropyl)ethane, 1,4-diaminobutane, laurylaminopropylamine, iminobispropylamine and methyliminobispropylamine, and aromatic polyamines such as meta-xylenediamine. And these amine compounds can be used alone or as a mixture of any two or more thereof. Examples of such alkylene oxides include ethylene oxide, propylene oxide and butylene oxide.

Examples of the polyisocyanate include not only aromatic polyisocyanates, such as diphenylmethane diisocyanate (MDI), tolylene diisocyanate (TDI) and naphthalene diisocyanate, but also aliphatic polyisocyanates, such as hexamethylene diisocyanate (HDI) and lysine methyl ester diisocyanate, and alicyclic polyisocyanates, such as hydrogenated diphenylmethane diisocyanatem, isophorone diisocyanate, norbornane diisocyanate and hydrogenated tolylenediisocyanate. Of these polyisocyanates, the use of MDI is preferred in terms of toxicity and price.

The isocyanate group-containing urethane prepolymers produced by subjecting the polyols to reaction with the polyisocyanates may be used alone or as a combination of any two or more thereof. When two or more among the urethane prepolymers are used in combination, there is no particular restriction as to which urethane prepolymers to be combined together, and prepolymers different in polyols or polyisocyanates used therefor, e.g. the prepolymers produced by using polypropylene glycol and an amine polyol, respectively, may be used in combination.

As to the conductive filler (B) to be used in a pulse light-curable composition according to the invention, conductive fillers known widely to have electrically conductive capability can be used, and there is no particular restrictions on them. Examples of such a filler include metal powders, such as silver powder, copper powder, gold powder, nickel powder, aluminum powder, metallic powders such as silver-plated powder, silver-coated glass, silver-coated silica and silver-coated plastics, zinc oxide, titanium oxide, ITO and ATO. In point of rapid curability, metal and metallic powders are preferable to the others, and silver powder and silver-plated powder are far preferred. As the metal powder, nanonized metal powder, such as nanonized silver powder referred to as nanosilver (particle size of which is from 1 to 100 nm), can also be used.

In addition to the conductive fillers recited above, silver salts of carboxylic acids, such as silver neodecanoate and silver oleate, and silver complexes, such as silver acetylacetonate complex and silver amine complex, can further be added. By addition of such a silver compound thereto, the pulse light-curable composition can provide a cured material further reduced in resistance.

The conductive filler (B) has no particular restrictions as to its shape, and it can be used in a variety of shapes, such as a flaky shape and a granular shape, but it is preferable to use flaky and granular conductive fillers in combination. In the invention, the term flaky shape is intended to include the shapes referred to as a flat shape, a flaky shape and a scaly shape, and it is formed by squashing particles of steric shapes, such as a spherical shape or a block shape, in one direction. On the other hand, the term granular shape means all shapes except flaked shapes, with examples including a shape which particulates assume by gathering in clusters like grapes, a spherical shape, a nearly spherical shape, a block shape, an arborescent shape, a spike-like shape and mixtures of two or more of these shapes.

The suitable 50%-average particle size of the conductive filler (B) is from 0.5 to 30 μm. The term 50%-average as used in this specification refers to the 50% particle size ($D_{50}$), which can be measured by means of e.g. a laser-Doppler particle-size distribution measurement system (Microtrac (trade mark) MT3000II, a particle-size distribution measuring instrument made by NIKKISO Co., LTD.).

In the invention, the conductive filler (B) has no particular restrictions as to the proportion in which it is mixed, but it is preferable that the conductive filler (B) constitutes 50 mass% to 85 mass% of the total amount (on solids basis) of conductive composition except the contents of solvent, diluent and plasticizer.

Examples of the condensation catalyst (C) to be used in a pulse light-curable composition according to the invention include titanic acid esters, such as tetrabutyl titanate and tetrapropyl titanate; organotin compounds including tetravalent tin compounds, such as dibutyltin dilaurate, dibutyltin maleate, dibutyltin diacetate, dibutyltin diacetylacetonate, dibutyltin oxide, dioctyltin dilaurate, dioctyltin maleate, dioctyltin diacetate, dioctyltin dineodecanate (dioctyltin diversatate), dioctyltin oxide and products of reaction between dibutyltin oxide and phthalic acid esters, and divalent tin compounds, such as tin dioctylate, tin dinaphthenate, tin distearate and tin dineodecanate (tin diversatate); organoaluminum compounds, such as aluminum trisacetylacetate, aluminum tricethylacetoacetate, diisopropoxyaluminum ethylacetoacetate and aluminum monoacetylacetonate bis(ethylacetoacetate); products of reaction between bismuth salts and organic carboxylic acids or organic amines, such as bismuth-tris(2-ethylhexoate) and bismuth-tris(neodecanoate); chelate compounds, such as zirconium tetraacetylacetonate, titanium diethoxide bis(ethylacetoacetate), titanium diisopropoxide bis(ethylacetoacetate), titanium dibutoxide bis(ethylacetoacetate) and titanium tetraacetylacetonate; organic lead compounds such as lead octylate; organic iron compounds such as iron naphthenate; organovanadium compounds; amine compounds, such as butylamine, octylamine, laurylamine, dibutylamine, monoethanolamine, diethanolamine, triethanolamine, diethylenetriamine, triethylenetetramine, oleylamine, cyclohexylamine, benzylamine, diethylaminopropylamine, xylylenediamine, triethylenediamine, guanidine, diphenylguanidine, 2,4,6-tris(dimethylaminomethyl)phenol, morpholine, N-methylmorpholine and 1,8-diazabicyclo(5.4.0)undecene-7 (DBU), and salts formed from these amines and carboxylic acid; low molecular-weight polyamide resins synthesized from excessive amounts of polyamines and polybasic acids; products of reaction between polyamines in excessive amounts and epoxy compounds; and well-known silanol composite catalysts including amino group-containing silane coupling agents, such as γ-aminopropyltrimethoxysilane and N-(β-aminoethyl)aminopropylmethyldimethoxysilane. These catalysts may be used alone or as a combination of any two or more thereof.

The condensation catalysts as recited above may be used alone or as a combination of any two or more thereof. Of those catalysts, organometallic compounds or combinations of organometallic compounds and amine compounds are preferred in terms of curability. Further, in point of rapid cure, dibutyltin maleate, products of reaction between dibutyltin oxide and phthalic acid esters, dibutyltin diacetylacetonate and dioctyltin dineodecanate are preferred over the others. On the other hand, in terms of environmental issues, dioctyltin compounds are preferred over the others. Moreover, in the case of using screen printing, gravure printing, flexographic printing or the like on the occasion that a pulse light-curable composition according to the invention is applied to or printed on a substrate, the composition is required to ensure an available time at ordinary temperature, and hence incorporation of an aluminum chelate compound into the composition is suitable for applying the composition to or printing the composition on a substrate by the use of the printing technique as cited above. And it is preferable that the curing catalyst is used in an amount of 0.1 to 10 parts by mass with respect to 100 parts by mass of resin as the component (A).

Into a pulse light-curable composition according to the invention may be mixed, if required for adjusting the viscosity and physical properties, a filling agent, a plasticizer, an adhesion-imparting agent, a stabilizer, a physical-property adjusting agent, a thixotropic agent, a hydrator (storage stability improver), a tackiness-imparting agent, a flame retardant, a radical polymerization initiator and so on, and besides, compatible other polymers may be blended.

Examples of the plasticizer include phthalic acid esters, such as diisodecyl phthalate, diundecyl phthalate, diisoundecyl phthalate, dioctyl phthalate, dibutyl phthalate and butyl benzyl phthalate; aliphatic dibasic acid esters, such as dimethyl adipate, dioctyl adipate, isodecyl succinate and dibutyl sebacate; glycol esters, such as diethylene glycol dibenzoate and pentaerythritol esters; aliphatic esters, such as butyl oleate and methyl acetylricinoleate; epoxy plasticizers, such as epoxidated soybean oil, epoxidated linseed oil and benzyl epoxystearate; polyester plasticizers such as polyesters produced by reaction between dibasic acids and dihydric alcohols; polyethers, such as polypropylene glycol and derivatives thereof; poly(meth)acrylic ester plasticizers, such as alkyl poly(meth)acrylates; polystyrenes, such as poly-$\alpha$-methylstyrene and polystyrene; and plasticizers such as polybutadiene, butadiene-acrylonitrile copolymer, polychloroprene, polyisoprene, polyisobutene, paraffinic hydrocarbons, naphthenic hydrocarbons, mixtures of paraffinic and naphthenic hydrocarbons, and chlorinated paraffin. These plasticizers can be used alone or as a mixture of any two or more thereof.

The plasticizers preferred in point of weather resistance in particular are polyether-based plasticizers such as polypropylene glycol having no unsaturated bonds in its main chain and derivatives thereof, poly(meth)acrylic ester plasticizers, polyisobutene, paraffin and the like. Among the plasticizers recited above, polymeric plasticizers, notably polyether-based plasticizers, such as polypropylene glycol and derivatives thereof, and poly(meth)acrylic ester plasticizers, are far preferred. In the case of using a plasticizer, it is preferable that the plasticizer is added in an amount of 1 to 200 parts by mass, preferably 5 to 150 parts by mass, with respect to 100 parts by mass of resin as the component (A).

The adhesion-imparting agent can be specifically explained with examples including but not limited to amino group-containing silanes, such as $\gamma$-aminopropyltrimethoxysilane, $\gamma$-aminopropyltriethoxysilane, $\gamma$-aminopropylmethyldimethoxysilane, N-($\beta$-aminoethyl)-$\gamma$-aminopropyltrimethoxysilane, N-($\beta$-aminoethyl)-$\gamma$-aminopropyltriethoxysilane, N-($\beta$-aminoethyl)-$\gamma$-aminopropylmethyldimethoxysilane and 1,3-diaminoisopropyltrimethoxysilane; ketimine-type silanes, such as N-(1,3-dimethylbutylidene)-3-(triethoxysilyl)-1-propaneamine and N-(1,3-dimethylbutylidene)-3-(trimethoxysilyl)-1-propaneamine; epoxy group-containing silanes, such as $\gamma$-glycidoxypropyltrimethoxysilane, $\gamma$-glycidoxypropyltriethoxysilane, $\gamma$-glycidoxypropylmethyldimethoxysilane and $\beta$-(3,4-epoxycyclohexyl)ethyltrimethoxysilane; mercapto group-containing silanes, such as $\gamma$-mercaptopropyltrimethoxysilane and $\gamma$-mercaptopropylmethyldimethoxysilane; vinyl-type unsaturated group-containing silanes, such as vinyltrimethoxysilane, vinyltriethoxysilane, $\gamma$-methacryloyloxypropyltrimethoxysilane and $\gamma$-acryloyloxypropylmethyldimethoxysilane; chlorine atom-containing silanes, such as $\gamma$-chloropropyltrimethoxysilane; isocyanate group-containing silanes, such as $\gamma$-isocyanatopropyltriethoxysilane and $\gamma$-isocyanatopropylmethyldimethoxysilane; and hydrosilanes, such as metyldimethoxysilane, trimethoxysilane and methyldiethoxysilane. Modified amino group-containing silanes may also be used which are obtained by modifying the amino groups in the amino group-containing silanes as recited above through the reaction with epoxy-containing compounds, isocyanato group-containing compounds or (meth)acryloyl group-containing compounds wherein the silanes as recited above are included.

The addition of adhesion-imparting agent in too large an amount causes the cured material to have too high a modulus, while the addition in too small an amount results in lowering of adhesive strength. Accordingly, it is preferable that the adhesion-imparting agent is added in an amount of 0.1 to 15 parts by mass, preferably 0.5 to 10 parts by mass, with respect to 100 parts by mass of resin as the component (A).

Examples of the filler include reinforcing fillers, such as fumed silica, precipitated silica, crystalline silica, fused silica, dolomite, silicic acid anhydride, hydrous silicic acid and carbon black; powdery fillers, such as ground calcium carbonate, colloidal calcium carbonate, magnesium carbonate, diatomaceous earth, calcined clay, clay, talc, titanium oxide, bentonite, organized bentonite, ferric oxide, aluminum fine powder, flint powder, zinc oxide, activated hydrozincite, Shirasu balloon, glass microballoon, organic microballoons of phenol resin and vinylidene chloride resin, and resin powders including PVC powder and PMMA powder; and fibrous fillers, such as asbestos and filament.

When such fillers are used, the amount of usage thereof is from 1 to 250 parts by mass, preferably from 10 to 200 parts by mass, with respect to 100 parts by mass of resin as the component (A). Those fillers may be used alone, or as a mixture of any two or more thereof.

The fillers can also be dehydrated and dried in advance, as described in JP-A-2001-181532, by homogeneously mixing them with a dehydrator such as calcium oxide, enclosing the mixture in a bag made of a hermetic material, and then letting the bag stand for an appropriate time. By using such fillers with low moisture contents, storage stability can be improved in the case where they are incorporated into a one-liquid type of composition in particular.

When it is desired to obtain a cured material of higher strength through the use of some of those fillers, the fillers are preferably chosen mainly from fumed silica, precipitated silica, crystalline silica, fused silica, dolomite, silicic acid anhydride, hydrous silicic acid and carbon black, surface-treated fine-grain calcium carbonate, calcined clay, clay, activated hydrozincite or the like, and desirable results can be achieved by using such fillers in an amount of 1 to 200

parts by mass with respect to 100 parts by mass of resin (A). On the other hand, when it is desired to obtain a cured material of low strength and great elongation at break, desirable results can be achieved by using fillers chosen mainly from titanium oxide, calcium carbonate such as ground calcium carbonate, magnesium carbonate, talc, ferric oxide, zinc oxide, Shirasu balloon or the like in an amount of 5 to 200 parts by mass with respect to 100 parts by mass of resin (A). By the way, the use of calcium carbonate having a greater specific surface value generally contributes to the greater improvements in the resulting cured material's tensile strength at break, elongation at beak and adhesion strength. In the case of using calcium carbonate, it is desirable to use surface-treated fine-grain calcium carbonate in combination with calcium carbonate having a large grain size, such as ground calcium carbonate. The grain size of surface-treated fine-grain calcium carbonate is preferably 0.5 μm or smaller, and it is preferred that the surface treatment be performed using a fatty acid or a fatty acid salt. In addition, the calcium carbonate larger in grain size preferably has a grain size of at least 1 μm, and calcium carbonate usable as such calcium carbonate is surface-untreated one.

For improvement in workability (including agility in working) of the composition, it is suitable to add organic balloon or inorganic balloon. These fillers can also undergo surface treatment, and each of them may be used singly, or they may be used as a mixture of any two or more thereof. For improvement in workability (including agility in working), it is preferable that the particle size of balloon is 0.1 mm or below.

In the invention, it is preferable to add silica for the purpose of preventing bleed while ensuring flowabiliy without causing an increase in viscosity. The silica may also have received surface treatment, and only one among various types of silica may be used, or a mixture of any two or more of various types of silica may be used. From the viewpoint of preventing bleed, it is preferable to use hydrophilic silica or hydrophobic silica having undergone hydrophobization by means of a specific surface treatment agent. The hydrophobic silica is preferably hydrophobic silica having undergone hydrophobization by means of at least one surface treatment agent selected from the group consisting of dimethyldichlorosilane, hexamethyldisilazane, (meth)acrylsilane, octylsilane (e.g. trimethoxyoctylsilane) and aminosilane.

For improvement in workability and lowering of viscosity, a solvent or a diluent may be mixed within the scope of allowing the achievement of the objects of the invention. Examples of such a solvent include aromatic hydrocarbon series solvents, such as toluene and xylene; ester-type solvents, such as ethyl acetate, butyl acetate, amyl acetate and cellosolve acetate; and ketone-type solvents, such as methyl ethyl ketone and methyl isobutyl ketone. Examples of such a diluent include normal paraffin and isoparaffin.

A tackiness-imparting agent may be added for improvement in ability to wet adherends and enhancement of peel strength. Examples of such an agent include tackiness-imparting resins of petroleum resin type, those of rosin-rosin ester type, those of acrylic resin type, terpene resin, hydrogenated terpene resin, copolymer of hydrogenated terpene resin and phenol resin, and those of phenol-phenol novolac resin type.

Examples of other additives include anti-dripping agent such as hydrogenated castor oil, organized bentonite or calcium stearate, a coloring agent, an antioxidant, an UV absorber and a light stabilizer. Further, when required, other additives, such as other resins including epoxy resin, curing agents for epoxy resin and so on, a physical properties-adjusting agent, a storage stability improver, a slip additive and a foaming agent, can be added as appropriate.

The pulse light-curable compositions according to the invention can be prepared into either one-liquid type of compositions or two-liquid type of compositions on an as-needed basis, but they may be favorably used in the form of one-liquid type in particular.

The pulse light-curable compositions according to the invention are liquid compositions, and they are therefore excellent in workability. It is preferable that the conductive composition in the invention has their 23°C viscosity in a range of 100 to 800 Pa.s.

The pulse light-curable compositions according to the invention can deliver high conductivity and be used as substitutes for solder by being applied to or printed on substrates and then cured. The pulse light-curable compositions according to the invention can be used suitably for various application purposes, such as bonding and implementation of electronic components including semiconductor device chip components and discrete components, connection between circuits, adhesion and fixation of quartz oscillators and piezoelectric elements, sealing of packages and so on. Through the use of the pulse light-curable compositions according to the invention, it is possible to form, on substrate surfaces, circuits where one or more kinds of electronic components, such as semiconductor devices, chip components and discrete components, are bonded together.

The pulse light-curable compositions according to the invention are useful in the use of heat-sensitive substrates in particular, and suitable for use in e.g. forming circuitry or implementing chips on a heat-sensitive substrate like PET. In addition, each of the pulse light-curable compositions according to the invention is also suitable for use in bonding a transparent substrate (a light transmissible material), which is located on the side to be exposed to pulse light, and a member together through the medium of the composition.

The pulse light-curable compositions according to the invention have no particular restrictions as to usage thereof, but it is preferred that the compositions according to the invention is used in fabricating wiring boards by carrying out at least one of the following processes (a) to (c).

Process (a): A process in which circuits or electrodes are formed by the pulse light-curable compositions according to the invention being applied to or printed on printed wiring boards or flexible printing substrates and then being irradiated with pulse light.

Process (b): A process in which electric continuity between layers is created by any of the pulse light-curable compositions according to the invention being charged into through holes of a multilayer board and then by the through holes being irradiated with pulse light.

Process (c): A process in which any of the pulse light-curable compositions according to the invention is applied to or printed on a printing substrate by means of a dispenser or by screen printing or stencil printing, further semiconductor devices and chip components are mounted on the composition, and then they are bonded to the composition through the irradiation with pulse light.

As to substrates to which the pulse light-curable compositions according to the invention are applied, any of organic substrates and inorganic substrates can be adopted. Examples of an organic substrate include, but not limited to, a PET (polyethylene terephthalate) substrate; paper base copper-clad laminates, such as paper/phenolic resin copper-clad laminates (FR-1, FR-2, XXXpc or Xpc), a paper/epoxy resin copper-clad laminate (FR-3) and a paper/polyester resin copper-clad laminate; glass base copper-clad laminates, such as glass cloth/epoxy resin copper-clad laminates (FR-4, G-10), heat-resistant glass cloth/epoxy resin copper-clad laminates (FR-5, G-11), a glass cloth/polyimide resin copper-clad laminate (GPY), glass cloth/fluorocarbon resin copper-clad laminates, multilayer materials [preimpregnated cloth/thin cloth](FR-4, FR-5, GPY) and inner layer circuit-containing multilayer copper-clad laminates (FR-4, FR-5, GPY); composite copper-clad laminates, such as a paper/glass cloth/epoxy resin copper-clad laminate (CEM-1), a glass nonwoven cloth/glass cloth/epoxy resin copper-clad laminate (CEM-3), a glass nonwoven cloth/glass cloth/polyester resin copper-clad laminate (FR-6) and glass mat/class cloth/polyester resin copper-clad laminates; flexible copper-clad plates, such as a polyester base copper-clad plate, a polyimide base copper-clad plate and a glass/epoxy base copper-clad plate; and heat-resistant thermoplastic substrates, such as a polysulfone resin substrate, a polyetherimide resin substrate and a polyether ketone resin substrate. Of these substrates, a PET substrate (including one which is in the form of film), is sensitive to heat, and it is suitable as a substrate to which are applied the pulse light-curable compositions according to the invention.

On the other hand, examples of an inorganic substrate include, but not limited to, metallic substrates, such as a metal base substrate, a metal core substrate and an enameled substrate; ceramic substrates, such as an alumina substrate, an aluminum nitride (AlN) substrate, a silicon carbide (SiC) substrate and a low-temperature fired substrate; and glass substrates.

Besides being used as substrates, the pulse light-curable compositions according to the invention can be us not only as circuits or contacts on ITO or IO glass electrodes, as circuits or contacts of NESA glass electrodes, as conductive contacts between glass sheets in the interior of a liquid crystal panel, for bonding of lead wire in the CdS part of a photoconductive device, for repair of circuits, for bonding of lead wire in a potentiometer, or as electrode parts of a solar battery, but also on metallic base materials such as external electrodes of tantalum capacitors, bonding part of a copper or aluminum electrode of an aluminum electrolytic capacitor, or contacting part and circuitry part of solar battery electrodes.

The pulse light-curable compositions according to the invention can be used in a state of being applied to, printed on or charged into the organic or inorganic substrates as recited above by means of devices or methods including mesh screen printing, stencil printing, gravure printing, offset lithography, flexography, inkjet printing, a roller coater, a dispenser, dipping and so on.

The pulse light-curable compositions according to the invention can be cured with rapidity by irradiation with pulse light. The pulse light in the invention is light emitted from a laser or a flash lamp, and the irradiation time measured at a point of 1/2 the intensity peak of irradiation light is preferably from 5 $\mu$s to 3,000 $\mu$s, particularly preferably from 20 $\mu$s to 2,000 $\mu$s. The integral of the irradiated energy is preferably from 10 to 200 $J/cm^2$, far preferably from 20 to 150 $J/cm^2$. The number of times that the irradiation is repeated is at least 10. When the irradiation time is below 1 millisecond in particular, it is preferable that the irradiation is repeated 100 times or above. The irradiation energy is measured using a thermopile of junction device array or a pyroelectric device. The pulse-light irradiation preferred in the invention is irradiation using a flash lamp in particular.

As the discharge tube in the flash lamp, a discharge tube in which xenon, helium, neon or argon is enclosed can be used, and a xenon-enclosed discharge tube is preferable to the others.

Giving a few examples of flash lamp apparatus usable in the invention, they are apparatus which is designed to give off discharge emission in a flash lamp enclosed with a gas like xenon and equipped with trigger wire, apparatus which is designed to produce pulse light through short-time high-power discharge in the atmosphere of an inert gas, and so on. Examples of the former apparatus can include SINTERON 2000 and RC series made by Xenon Corporation, and examples of the latter apparatus can include PulseForge 3100 made by NovaCentrix.

In the method of using the pulse light-curable compositions according to the invention, individual steps can be

performed in known manners and under known conditions, except by using as conductive paste the pulse light-curable compositions according to the invention.

**Examples**

The invention will now be illustrated in more detail by reference to the following examples, and these examples are exemplary embodiments of the invention and should not be construed as limiting the invention in any way.

(Synthesis Example 1)

Under an atmosphere of nitrogen, CuBr (1.09 kg), acetonitrile (11.4 kg), butyl acrylate (26.0 kg) and ethyl 2,5-dibromoadipate (2.28 kg) were put in a 250L reactor, and stirred at a temperature of 70°C to 80°C for about 30 minutes. Thereto, pentamethyldiethylenetriamine was added, thereby initiating reaction. After a passage of 30 minutes from the initiation of the reaction, butyl acrylate (104 kg) was further added to the reactor continuously over 2 hours. In the middle way of the reaction, pentamethyldiethylenetriamine was added as appropriate, and thereby the temperature inside the reactor was adjusted to fall in a range of 70°C to 90°C. The total amount of pentamethyldiethylenetriamine used until this reaction stage was 220 g. After a passage of 4 hours from the initiation of the reaction, heating and stirring were carried out at 80°C under reduced pressure, thereby removing volatile components. To the resulting reaction mixture, acetonitrile (45.7 kg), 1,7-octadiene (14.0 kg) and pentamethyldiethylenetriamine (439 g) were added and subjected to 8-hour continuous stirring. The resulting mixture was heated at 80°C with stirring under reduced pressure, and thereby volatile components were removed from the mixture. To the thus obtained condensate, toluene was added to dissolve polymers therein. Further thereto, diatomaceous earth as a filter aid, and aluminum silicate and hydrotalcite as adsorbents were added, and heated at an inside temperature of 100°C with stirring in an atmosphere of an oxygen-nitrogen gas mixture (oxygen concentration of 6%). The solid matter in the resulting mixed solution was removed by filtration, and the filtrate was heated at an internal temperature of 100°C with stirring, and thereby volatile components were removed from the filtrate.

Further to this concentrate, aluminum silicate and hydrotalcite as adsorbents and a thermal degradation inhibitor were added, and heated with stirring under reduced pressure (average temperature: about 175°C, degree of reduced pressure: 10 Torr or below).

Thereto, aluminum silicate and hydrotalcite as adsorbents were further added and an antioxidant was also added, and heated at an inside temperature of 150°C with stirring in an atmosphere of an oxygen-nitrogen gas mixture (oxygen concentration of 6%). To the thus obtained condensate, toluene was added to dissolve polymers therein, the solid matter in the resulting mixed solution was removed by filtration, and the filtrate was heated with stirring under reduced pressure, and thereby volatile components were removed from the filtrate. Thus, an alkenyl group-containing polymer was obtained. The thus obtained alkenyl group-containing polymer, dimethoxymethylsilane (2.0 molar equivalent to the alkenyl groups), methyl orthoformate (1.0 molar equivalent to the alkenyl groups) and a platinum catalyst [xylene solution of a bis(1,3-divinyl-1,1,3,3-tetramethyldisiloxane)platinum complex catalyst, 10 mg as platinum with respect to 1 kg of the polymer] were mixed, and heated at 100°C with stirring in an atmosphere of nitrogen. After checking up on the disappearance of alkenyl groups, the reaction mixture was concentrated, thereby yielding terminal dimethoxysilicon-containing group-containing poly(n-butylacrylate), polymer A1. The thus obtained polymer A1 had a number-average molecular weight of about 26,000, an Mw/Mn of 1.3 and Tg of - 56.0°C. The average number of silicon-containing groups introduced into one molecule of the polymer was determined by $^1$H NMR analysis, and it was found to be about 1.8.

(Synthesis Example 2)

Into a flask, 40 parts by mass of ethyl acetate as a solvent, 59 parts by mass of methyl methacrylate, 25 parts by mass of 2-ethylhexyl methacrylate, 21 parts by mass of γ-methacryloxypropyltrimethoxysilane and 0.1 parts by mass of rhuthenocene dichloride as a metallic catalyst were charged, and heated up to 80°C as a nitrogen gas was admitted thereinto. And subsequently 7.5 parts by mass of 3-mercaptopropylmethyldimethoxysilane was added to the interior of the flask, and reaction was carried out at 80°C for 6 hours. After cooling to room temperature, the polymerization was stopped by addition of 20 parts by mass of a solution of benzoquinone (a 95% THF solution). The solvents and unreacted matter were distilled away, and thus was obtained a dimethoxysilyl group-containing acrylate base polymer, polymer A2, having a number-average molecular weight of about 6,000 as calculated in terms of polystyrene, an Mw/Mn of 1.6 and Tg of 61.2°C.

(Synthesis Example 3)

Into a flask, 40 parts by mass of ethyl acetate as a solvent, 59 parts by mass of methyl methacrylate, 25 parts

by mass of 2-ethylhexyl methacrylate, 22 parts by mass of γ-methacryloxypropyltrimethoxysilane and 0.1 parts by mass of rhuthenocene dichloride as a metallic catalyst were charged, and heated up to 80°C as a nitrogen gas was admitted thereinto. And subsequently 8 parts by mass of 3-mercaptopropyltrimethoxysilane was added to the interior of the flask, and reaction was carried out at 80°C for 6 hours. After cooling to room temperature, the polymerization was stopped by addition of 20 parts by mass of a solution of benzoquinone (a 95% THF solution). The solvents and unreacted matter were distilled away, and thus was obtained a trimethoxysilyl group-containing acrylate base polymer, polymer A3, having a number-average molecular weight of about 6,000 as calculated in terms of polystyrene, an Mw/Mn of 1.6 and Tg of 61.2°C.

(Synthesis Example 4)

Into a flask equipped with a stirrer, a nitrogen gas introduction tube, a thermometer, a dropping instrument and a reflux condenser, 100 g of 3-aminopropyltrimethoxysilane (Z-6610, trade name, a silicone produced by Dow Corning Toray Co., Ltd.) and 276 g of 3-glycidoxypropyltrimethoxysilane (Z-6040, trade name, a silicone produced by Dow Corning Toray Co., Ltd.) were charged, and stirred for 72 hours at 50°C to yield carbasilatrane. The carbasilatrane obtained was checked up on the absence of a peak at around 910 $cm^{-1}$ ascribed to epoxy groups and the presence of a peak at around 1,140 $cm^{-1}$ ascribed to secondary amine groups through the use of FT-IR, and besides it was able to ascertain the appearance of a new peak in a range of -60 ppm to -70 ppm by $^{29}$Si-NMR measurement.

(Synthesis Example 5)

Into a flask equipped with a stirrer, a nitrogen gas introduction tube, a thermometer, a dropping instrument and a reflux condenser was charged 100 g of the carbasilatrane obtained in Synthesis Example 4, and subsequently was charged 63.1 g of Orgatics TC-750 [trade name, titanium diisopropoxybis(ethyl acetoacetate) produced by Matsumoto Fine Chemical Co., Ltd.). The resulting mixture was ripened by heating at 70°C with stirring for 144 hours, thereby forming a synthetic titanium catalyst. The synthetic titanium catalyst obtained was checked up on the change in peaks of $^{29}$Si-NMR spectra.

(Example 1)

As shown in Table 1, 80 parts by mass of the resin obtained in Synthesis Example 1, 20 parts by mass of the resin obtained in Synthesis Example 2 and 5 parts by mass of Aerosil R972 (trade name, dimethyldichlorosilane-treated hydrophobic silica produced by NIPPON AEROSIL CO., LTD.) were stirred with an agitation mixer as defoaming was carried out, and then dehydrated at 100°C for 1 hour, and further cooled down to 50°C or below. Thereto, the remainder of the 4 ingredients to be mixed were added, stirred and defoamed, thereby yielding a pulse light-curable composition in a paste state.

Table 1

| Example Number | 1 | 2 | 3 | 4 | 5 | 6 | 7 | 8 | 9 |
|---|---|---|---|---|---|---|---|---|---|
| (A) Polymer A1 | 80 | 80 | 80 | 80 | | | | | |
| (A) Polymer A2 | 20 | 20 | 20 | 20 | | | | | |
| (A) MA440*1 | | | | | 100 | 100 | 100 | | |
| (A) EP505S*2 | | | | | | | | 100 | 100 |
| (A) Polymer A3 | | | | | | | | | 20 |
| Aerosil R972*3 | 5 | 5 | 5 | 5 | 5 | 5 | 5 | 5 | 5 |
| AO-60*4 | 3 | 3 | 3 | 3 | 3 | 3 | 3 | 3 | 3 |
| NOCRAC CD*5 | 3 | 3 | 3 | 3 | 3 | 3 | 3 | 3 | 3 |
| LA-63P*6 | 3 | 3 | 3 | 3 | 3 | 3 | 3 | 3 | 3 |
| (B) SILCOAT AgC-B*7 | 300 | 300 | 300 | | 300 | 300 | 300 | 300 | 360 |
| (B) SILCOAT AgC-B*8 | 200 | 200 | 200 | | 200 | 200 | 200 | 200 | 240 |
| (B) ACAX-3*9 | | | | 150 | | | | | |

(continued)

| Example Number | 1 | 2 | 3 | 4 | 5 | 6 | 7 | 8 | 9 |
|---|---|---|---|---|---|---|---|---|---|
| (B) 1400YP(10%)*10 | | | | 150 | | | | | |
| N-11*11 | 30 | 30 | 30 | 30 | 30 | 30 | 30 | 30 | 30 |
| Dimethyl adipate | 10 | 10 | 10 | 10 | | | | 10 | 10 |
| KBM-1003*12 | 3 | 3 | 3 | 3 | 3 | 3 | 3 | 3 | 3 |
| KBM-903 *13 | 6 | 6 | | | 6 | 6 | | 6 | 6 |
| (C) Aluminum chelate D*14 | 6 | | | 6 | 6 | | | 6 | 6 |
| (C) U-800P*15 | | 0.5 | | | | 0.5 | | | |
| Synthetic titanium catalyst | | | 10 | | | | 10 | | |
| Content (mass%) (solid content) | 79.5 | 80.2 | 79.7 | 70.9 | 79.5 | 80.2 | 79.7 | 79.5 | 80.1 |

In Table 1, the amount of each ingredient mixed is expressed in gram. Polymers A1 to A3 are the polymers A1 to A3 obtained in Synthesis Examples 1 to 3, respectively. Synthetic titanium catalyst is the synthetic titanium catalyst obtained in Synthesis Example 5, and 38.7% of 10 parts by mass of the synthetic titanium catalyst is the equivalent of the condensation catalyst as Component (C).

The marks * 1 to * 15 in Table 1 indicate the following ingredients.

*1) MA440: Silyl MA440, trade name, produced by Kaneka Corporation, a mixture of a dimethoxysilyl-terminated polymer having polyoxypropylene as its main chain and a dimethoxysilyl-terminated polymer having a polymethacrylic ester copolymer as its main chain.

*2) EP-505S: Epion EP-505S, trade name, produced by Kaneka Corporation, a methyldimethoxysilyl-terminated polymer having polyisobutylene as its main chain and containing 33 wt% of process oil.

*3) Aerosil R972: Trade name, dimethyldichlorosilane-treated hydrophobic silica produced by NIPPON AEROSIL CO., LTD.

*4) AO-60: A phenolic antioxidant produced by ADEKA CORPORATION.

*5) NOCRAC CD: Trade name, 4,4'-bis($\alpha$,$\alpha$-dimethylbenzyl)diphenylamine produced by OUCHI SHIKO CHEMICAL INDUSTRIAL CO., LTD.

*6) LA-63P: Trade name, a hindered amine base anti-aging agent produced by ADEKA CORPORATION.

*7) SILCOAT AgC-B: Trade name, a flaky silver powder produced by FUKUDA METAL FOIL & POWDER CO., LTD. and having a specific surface of 1.35 $m^2/g$, a tap density of 4.6 $g/cm^3$ and a 50%-average particle size of 4 $\mu m$.

*8) SILCOAT AgC-G: Trade name, a granular silver powder (reduced powder) produced by FUKUDA METAL FOIL & POWDER CO., LTD. and having a specific surface of 2.5 $m^2/g$ and a tap density of 1.4 $g/cm^3$.

*9) ACAX-3: Trade name, a silver-plated copper powder produced by MITSUI MINING & SMELTING CO., LTD., wherein the copper powder used is dendritic copper powder and the percentage of silver is 20% by weight.

*10) 1400YP (10%): A silver-plated copper powder produced by MITSUI MINING & SMELTING CO., LTD., wherein the copper powder used is 1400YP (copper powder) and the percentage of silver is 10% by weight.

*11)N-11: Cactus Normal Paraffin N-11, trade name, a paraffin-based diluent produced by JX NIPPON OIL & ENERGY CORPORATION.

*12) KBM-1003: Trade name, vinyltrimethoxysilane produced by Shin-Etsu Chemical co., Ltd.

*13) KBM-903: Trade name, 3-aminopropyltrimethoxysilane produced by Shin-Etsu Chemical Co., Ltd.

*14) Aluminum Chelate D: Trade name, aluminum monoacetylacetonatebis(ethyl acetoacetate) produced by Kawaken Fine Chemicals Co., Ltd.

*15) U-800P: NEOSTANN U-800P, trade name, dioctyltin oxide produced by NITTO KASEI CO., LTD.

In Table 1, the wording "conductive filler (B) content (mass%) (solid content)" means the proportion (expressed in wt%) of conductive filler (B) to the remainder after excepting the solvent, the diluent and the plasticizers (N-11 and dimethyl adipate) from the whole of each pulse light-curable composition.

On each of the pulse light-curable compositions obtained in Examples, the following measurements 1) to 4) were made individually.

1) Testing for Curability under Irradiation with Pulse Light

Each of the pulse light-curable compositions was screen-printed on a PET film (thickness: 100 μm, LUMIRROR 100S, a product of Toray Industries Inc.) through the use of a metal mask having a thickness of 75 μm, thereby forming a pattern of conductor traces having a width of 1.0 mm, a trace spacing of 1 mm and a length of 70.0 mm, and immediately after printing it was irradiated with pulse light by using a xenon pulse irradiation device RC-802 made by US Xenon Corporation under the following irradiation conditions.

- Pulse width: 168 μsec
- Irradiation time: 10 sec
- Irradiation distance: 25 mm
- Integral of the amount of irradiated energy: 55 J/cm$^2$
- Type of the lamp used: LH-810 (pulse energy: 207 J/pulse)

After the irradiation, the cured state of each pulse light-curable composition was assessed on the following evaluation criteria. Results obtained are shown in Table 2.

• Evaluation criteria

A: cured, B: partially uncured, C: uncured.

2) Testing for Distortion Caused in PET by Irradiation with Pulse Light

After the testing for curability under irradiation with pulse light, the degree of distortion caused in each PET film was assessed on the following criteria. Results obtained are shown in Table 2.

• Evaluation criteria

A: Not distorted, B: Partially distorted, C: Distorted.

3) Testing for Conductivity

After the testing for curability under irradiation with pulse light, the resistance across the circuit pattern's ends was measured by means of a resistance meter RM3548 made by HIOKI E.E. CORPORATION. Cases where the resistance is beyond 1.0 MΩ, the upper measurement limit, are denoted as N.D. Results obtained are shown in Table 2.

4) Tape Peel Test

After the testing for curability under irradiation with pulse light, adhesive tape was stuck to the conductor traces formed from each pulse light-curable composition, then the tape was subjected to swift peel-back, and the state after the peel-back was observed. Results obtained are also shown in Table 2.

• Evaluation criteria

A: Nothing is peeled off, B: The peeled-off area is 50% or below, C: All are peeled off the PET film.

(Examples 2 to 9)

Pulse light-curable compositions were prepared individually in the same manner as in Example 1, except that the ingredients mixed together were changed as shown in Table 1. On each of the thus obtained pulse light-curable compositions, the measurements 1) to 4) were made individually in the same manners as in Example 1. Results obtained are shown in Table 2.

Table 2

| Example Number | 1 | 2 | 3 | 4 | 5 | 6 | 7 | 8 | 9 |
|---|---|---|---|---|---|---|---|---|---|
| Curability | A | A | A | A | A | A | A | A | A |
| Distortion of PET | A | A | A | A | A | A | A | A | A |
| Conductivity (Ω) | 0.8 | 0.7 | 0.7 | 1.2 | 0.8 | 0.7 | 0.8 | 1.2 | 0.9 |
| Tape Peel Test | A | A | A | A | A | A | A | A | A |

As shown in Table 2, all of the pulse light-curable compositions prepared in Examples 1 to 9 not only exhibited excellent conductivity and rapid curability but also caused no distortion in a heat-sensitive PET film even when each of them was applied to the PET film. In addition, they were easily peeled off the PET film, and exhibited good peelability.

(Examples 10 and 11)

The pulse light-curable composition described in Example 1 was screen-printed on a PET film (thickness: 100 μm, LUMIRROR 100S, a product of Toray Industries Inc.) through the use of a metal mask having a thickness of 75 μm, thereby forming a pattern of conductor traces having a width of 1.0 mm, a trace spacing of 1 mm and a length of 70.0 mm, and immediately after printing it was irradiated with pulse light by using a xenon pulse irradiation device SINTERON 2000 made by US Xenon Corporation under the following irradiation conditions.
In Example 10, the irradiation with pulse light was performed under the following conditions.

- Pulse width: 500 μsec
- Voltage: 3,800 V
- Irradiation time: 10 sec
- Irradiation distance: 25 mm
- Amount of irradiated energy: 55 J/$cm^2$

In Example 11, the irradiation with pulse light was performed under the following conditions.

- Pulse width: 2,000 μsec
- Voltage: 2,000 V
- Irradiation time: 10 sec
- Irradiation distance: 25 mm
- Amount of irradiated energy: 29 J/$cm^2$

After the irradiation, the same tests as the foregoing 1) to 4) were made. Results obtained are shown in Table 3.

(Example 12)

To 100 parts by mass of a deoximation-type silicone sealant produced by CEMEDINE Co., Ltd., 300 parts by mass of SILCOAT AgC-B, a product of FUKUDA METAL FOIL & POWDER CO., LTD., 200 parts by mass of SILCOAT AgC-G, a product of FUKUDA METAL FOIL & POWDER CO., LTD., and 30 parts by mass of Cactus Normal Paraffin N-11, a product of JX NIPPON OIL & ENERGY CORPORATION, were added, stirred and defoamed, thereby preparing a pulse light-curable composition in paste form.
On the thus prepared pulse light-curable composition, tests were made under the same conditions as in Example 10. Results obtained are shown in Table 3.

Table 3

| Example Number | 10 | 11 | 12 |
|---|---|---|---|
| Curability | A | A | A |
| Distortion of PET | A | A | A |
| Conductivity (Ω) | 0.9 | 0.8 | 1.4 |
| Tape Peel Test | A | A | B |

As shown in Table 3, all of the pulse light-curable compositions prepared in Examples 10 to 12 exhibited excellent rapid curability but also caused no distortion in a heat-sensitive PET film even when each of them was applied to the PET film. In addition, they were easily peeled off the PET film, and exhibited good peelability. Further, in terms of conductivity, these pulse light-curable compositions stood on a par with the compositions prepared in Examples 1 to 9.

(Comparative Examples 1 to 5)

Pulse light-curable compositions in paste form were prepared individually in the same manner as in Example 1, except that the ingredients mixed together were changed as shown in Table 4. On each of the thus obtained pulse light-curable compositions, the measurements 1) to 4) were made individually in the same manners as in Example 1. Results obtained are shown in Table 5.

Table 4

| Comparative Example Number | 1 | 2 | 3 | 4 | 5 |
|---|---|---|---|---|---|
| (A) Polymer A1 | 80 | 80 | 80 | 80 | 80 |
| (A) Polymer A2 | 20 | 20 | 20 | 20 | 20 |
| (A) MA440*1 | | | | | |
| (A) EP505S*2 | | | | | |
| (A) Polymer A3 | | | | | |
| Aerosil R972*3 | 5 | 5 | 5 | 5 | 5 |
| AO-60*4 | 3 | 3 | 3 | 3 | 3 |
| NOCRAC CD*5 | 3 | 3 | 3 | 3 | 3 |
| LA-63P*6 | 3 | 3 | 3 | 3 | 3 |
| HIGILITE H32*16 | 200 | 200 | 200 | | |
| WHITON SB*17 | | | | 40 | 40 |
| KALFAIN 200*18 | | | | 20 | 20 |
| N-11*11 | 30 | 30 | 30 | 30 | 30 |
| Dimethyl adipate | 10 | 10 | 10 | 10 | 10 |
| KBM- 1003 *12 | 3 | 3 | 3 | 3 | 3 |
| KBM-903*13 | 6 | 6 | | 6 | 6 |
| (C) Aluminum chelate D*14 | 6 | | | 6 | |
| (C) U-800P*15 | | 0.5 | | | 0.5 |
| Synthetic titanium catalyst | | | 10 | | |
| Filler content (mass%) (in all ingredients) | 37.6 | 37.6 | 37.6 | 16.8 | 16.8 |
| Filler content (mass%) (solid content) | 46.3 | 46.3 | 46.3 | 22.4 | 22.4 |

In Table 4, the amount of each ingredient mixed is expressed in gram. Polymers A1 to A3 are the polymers A1 to A3 obtained in Synthesis Examples 1 to 3, respectively. Synthetic titanium catalyst is the synthetic titanium catalyst obtained in Synthesis Example 5, and 38.7% of 10 parts by mass of the synthetic titanium catalyst is the equivalent of the condensation catalyst as Component (C). The marks *1 to *6 and *11 to *15 indicate the same ingredients as in Table 1, and the marks *16 to *18 indicate the following ingredients.

*16) HIGILITE H-32: Aluminum hydroxide (average particle size: 8 μm), a product of SHOWA DENKO K.K.
*17) WHITON SB: Trade name, dry ground calcium carbonate (average grain size: 2.2 μm), a product of SHIRAISHI CALCIUM KAISHA LTD.
*18) KALFAIN 200: Trade name, calcium carbonate surface-treated with a fatty acid (primary particle size (observed under an electron microscope): 0.07 μm), a product of MARUO CALCIUM CO., LTD.

Table 5

| Comparative Example Number | 1 | 2 | 3 | 4 | 5 |
|---|---|---|---|---|---|
| Curability | B | A | B | C | C |
| Distortion of PET | C | C | C | C | C |
| Conductivity (Ω) | N.D. | N.D. | N.D. | N.D. | N.D. |
| Tape Peel Test | C | A | C | - | - |

**Claims**

1. A method of producing a conductive cured material, wherein the conductive cured material is formed by application of pulsed light to a composition comprising:

   (A) at least one moisture-curable resin selected from the group consisting of an organic polymer containing a cross-linkable silicon-containing group and a moisture-curable urethane-based organic polymer;
   (B) a conductive filler; and
   (C) a condensation catalyst.

2. The method of producing a conductive cured material as described in claim 1, wherein the conductive cured material is formed on a base material.

3. A method of curing a pulse light-curable composition, wherein the curing is performed by application of pulsed light to a composition comprising:

   (A) at least one moisture-curable resin selected from the group consisting of an organic polymer containing a cross-linkable silicon-containing group and a moisture-curable urethane-based organic polymer;
   (B) a conductive filler; and
   (C) a condensation catalyst.

4. A pulse light-curable composition comprising:

   (A) at least one moisture-curable resin selected from the group consisting of an organic polymer containing a cross-linkable silicon-containing group and a moisture-curable urethane-based organic polymer;
   (B) a conductive filler; and
   (C) a condensation catalyst.

5. A conductive cured material produced according to a method as described in claim 1 or 2.

6. An electronic circuit formed with a conductive cured material as described in claim 5.

## INTERNATIONAL SEARCH REPORT

International application No. PCT/JP2014/067804

A. CLASSIFICATION OF SUBJECT MATTER
*C08L101/10*(2006.01)i, *C08K3/00*(2006.01)i, *C08K5/00*(2006.01)i, *C08L75/04*(2006.01)i, *H01B1/22*(2006.01)i, *H01B13/00*(2006.01)i, *H05K1/09*(2006.01)i, *H05K3/12*(2006.01)i

According to International Patent Classification (IPC) or to both national classification and IPC

B. FIELDS SEARCHED

Minimum documentation searched (classification system followed by classification symbols)
C08L1/00-101/16, C08K3/00-3/22, C08K5/04-5/357, C08K5/54-5/549, C08K5/56-5/58, H01B1/22, H01B13/00, H05K1/09, H05K3/12

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2004-241489 A (Sekisui Chemical Co., Ltd.), 26 August 2004 (26.08.2004), claims; paragraphs [0024] to [0025], [0027] to [0035], [0051], [0095] to [0097], [0153] to [0156], [0159] to [0162]; examples (Family: none) | 4-6<br>1-3 |
| X<br>A | JP 2009-286977 A (Three Bond Co., Ltd.), 10 December 2009 (10.12.2009), claims; paragraphs [0027] to [0036], [0093]; examples & WO 2009/144925 A1 & CN 102015906 A | 4-6<br>1-3 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>11 September, 2014 (11.09.14) | Date of mailing of the international search report<br>22 September, 2014 (22.09.14) |
| Name and mailing address of the ISA/<br>Japanese Patent Office<br>Facsimile No. | Authorized officer<br><br>Telephone No. |

Form PCT/ISA/210 (second sheet) (July 2009)

INTERNATIONAL SEARCH REPORT

International application No.
PCT/JP2014/067804

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2009-209299 A (The Chugoku Electric Power Co., Inc., Chuden-Kogyo Co., Ltd.),<br>17 September 2009 (17.09.2009),<br>claims; paragraphs [0028], [0072]; examples<br>(Family: none) | 4-6<br>1-3 |
| P,X | JP 2014-26968 A (Cemedine Co., Ltd.),<br>06 February 2014 (06.02.2014),<br>claims; paragraphs [0017], [0083] to [0085], [0099] to [0100], [0114] to [0121]; examples<br>(Family: none) | 1-6 |
| A | JP 2005-539110 A (3M Innovative Properties Co.),<br>22 December 2005 (22.12.2005),<br>claims; paragraphs [0025] to [0032], [0039] to [0040]; examples<br>& US 2004/0053059 A1 & WO 2004/024823 A1<br>& CA 2497274 A & KR 10-2005-0043948 A<br>& AU 2003248829 A & MX PA05002596 A | 1-6 |
| A | JP 2007-123260 A (TDK Corp.),<br>17 May 2007 (17.05.2007),<br>claims; paragraphs [0031] to [0032], [0058]; examples<br>(Family: none) | 1-6 |
| A | JP 2004-314640 A (TS Corp.),<br>11 November 2004 (11.11.2004),<br>claims; paragraphs [0079] to [0081]<br>& US 5014207 A & EP 393677 A2<br>& DE 69022274 C & DE 69022274 D<br>& AU 5376190 A & HK 150296 A<br>& KR 10-0122467 B & CN 1046615 A<br>& CA 2014810 A1 & JP 3-21432 A | 1-6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2000319622 A
- JP 2005089559 A
- JP 61197631 A
- JP 61215622 A
- JP 61215623 A
- JP 46027250 B
- JP 59015336 B
- JP 4536319 B
- JP 46012154 B
- JP 50156599 A
- JP 54006096 A
- JP 55013767 A
- JP 57164123 A
- JP 3002450 B
- JP 2005213446 A
- JP 2005306891 A
- WO 2007040143 A
- US 3632557 A
- US 4345053 A
- US 4960844 A
- JP 4069659 B
- JP 7108928 B
- JP 63254149 A
- JP 6422904 A
- JP 1197509 A
- JP 2539445 B
- JP 2873395 B
- JP 7053882 A
- JP 59122541 A
- JP 63112642 A
- JP 6172631 A
- JP 11116763 A
- JP 1168764 A
- JP 2000186176 A
- JP 59078223 A
- JP 59168014 A
- JP 60228516 A
- JP 60228517 A
- JP 2001181532 A


### Non-patent literature cited in the description


- **J.P. KENNEDY et al.** *J. Polymer Sci., Polymer Chem. Ed,* 1997, vol. 15, 2843